Europäisches Patentamt

European Patent Office

Office européen des brevets

(11) Publication number: **0 090 104**
**B1**

# EUROPEAN PATENT SPECIFICATION

(45) Date of publication of patent specification: **13.01.88**

(51) Int. Cl.⁴: **H 03 F 3/72**

(21) Application number: **82301599.5**

(22) Date of filing: **26.03.82**

(54) **Dual polarity switchable operational amplifier circuit.**

(43) Date of publication of application:
**05.10.83 Bulletin 83/40**

(45) Publication of the grant of the patent:
**13.01.88 Bulletin 88/02**

(84) Designated Contracting States:
**DE FR GB**

(56) References cited:
**DE-A-1 280 306**
**DE-A-2 851 410**
**FR-A-2 148 774**
**US-A-3 452 289**

**RADIO FERNSEHEN ELEKTRONIK, vol. 30, no. 3, March 1981, pages 184-185, Berlin (DDR); G.HALT: "Elektronischer Schalter mit Operationsverstärkereigenschaften"**

The file contains technical information submitted after the application was filed and not included in this specification

(73) Proprietor: **International Business Machines Corporation**
**Old Orchard Road**
**Armonk, N.Y. 10504 (US)**

(72) Inventor: **Cole, Terence George**
**54 Bassett Crescent West**
**Southampton Hampshire, S01 7DX (GB)**
Inventor: **Smith, Colin**
**1 Upper Brownhill Road Maybush**
**Southampton Hampshire, S01 6NG (GB)**

(74) Representative: **Bailey, Geoffrey Alan**
**IBM United Kingdom Limited Intellectual Property Department Hursley Park**
**Winchester Hampshire SO21 2JN (GB)**

Courier Press, Leamington Spa, England.

EP 0 090 104 B1

## Description

The invention relates to a dual polarity switchable input operational amplifier circuit operable in response to a signal applied to a polarity select input to provide a voltage output of either polarity for the same value input current.

Such an operational amplifier is shown incorporated as part of a four-bit, dual polarity multiplying digital-to-analogue converter described in IBM Technical Disclosure Bulletin, Vol. 24, No. 5, Oct. 1981, on pages 2432 to 2434. (IBM is a registered trade mark of International Business Machines Corporation.) In this article, a four-bit multiplying digital-to-analogue converter with unidirectional current output feeds a current mirror which performs voltage level shift and current reversal. The mirror can be switched off, if required, to provide zero output irrespective of input conditions and feeds a switchable input operational amplifier which generates output voltage signals of the required gain switchable to either polarity for all digital input values. Details of the operational amplifier circuit capable of performing this required function are not disclosed in the article.

One operational amplifier capable of producing an inverted or non-inverted signal output dependent on a voltage level present at the positive control input of the amplifier is described in an article 'plus or minus unity gain' Elektor (GB) Vol. 6, July/August 1980 at page 7—25.

It is becoming more common in the computer industry to build circuits from a basic building block of a single chip on which a predetermined set of devices are provided. Since the number of different devices available on such a chip is limited, being dependent on the technology employed, considerable skills and ingenuity need to be exercised in order to design circuits with the desired functions using only the available devices. A basic building block, known as master slice used by IBM provides a plurality of logic devices constructed using bi-polar technology. Although analogue circuits can be built using the technology predominantly intended for the construction of logic devices, this imposes limitation and many circuits cannot be made in this way without recourse to the use of externally connected discrete components. Apart from this constraint imposed by the available technology, there is additionally considerable incentive to make the most economic use of the devices so as to put as much function on each master slice chip as possible.

The IBM master slice is built using Zircon technology which is not adaptable for the construction of various high frequency devices including FETs, on the chip. One obvious problem associated with the circuit described in the Elektor article is that the switching operation depends upon a FET device and since this cannot be constructed on the master slice using Zircon technology the disclosed amplifier is quite unsuitable. Additionally, the use of a FET device in this way to control switching of the amplifier would inevitably introduce off-sets which would be translated to the output and modification with use of additional devices would be necessary.

The invention as claimed overcomes this problem by a unique design of amplifier circuit which performs the desired switching function; requires only those components which can be formed on the chip using the technology of the chip without the need for external components; and is extremely economical in its use of components.

Briefly, the invention achieves these advantages by providing a switchable dual input operational amplifier with two feedback resistors connected so that the amplifier operates as an inverting amplifier when one set of inputs are selected and as a non-inverting amplifier when the other set of inputs is selected, the two resistors individually determining the gain of the amplifier for each polarity, the circuit connections being such that when operating in one polarity, the resistor associated with the other polarity has no effect and vice versa.

In order that the invention may be fully understood, a preferred embodiment thereof will now be described with reference to the accompanying drawings, in which:

Figure 1 shows in schematic form a dual polarity operational amplifier according to the present invention; and

Figure 2 shows the detailed construction of the circuit formed using the technology of the master slice chip.

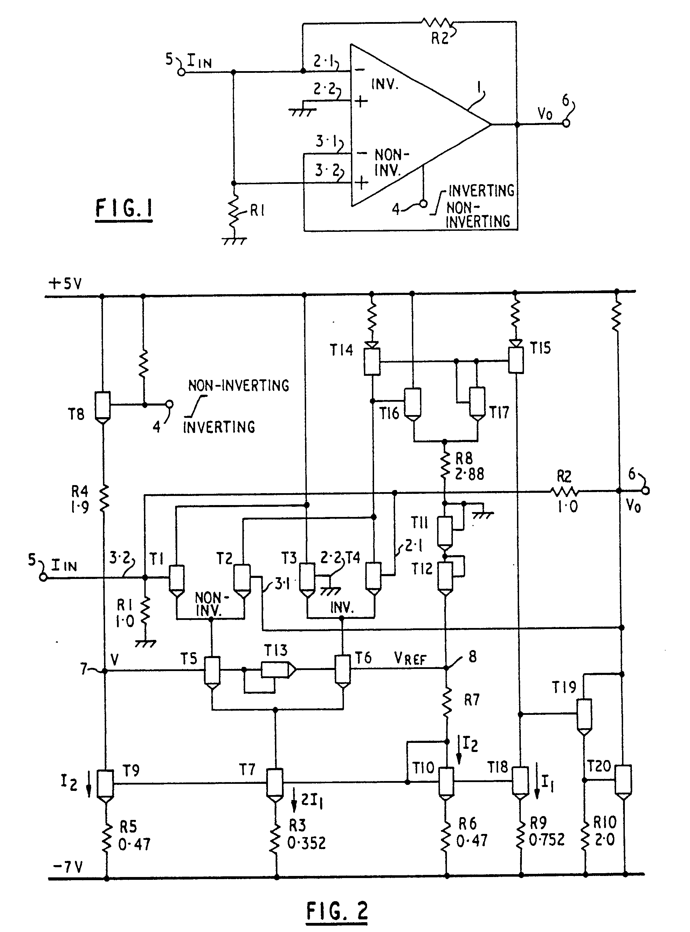

The circuit shown schematically in Figure 1 consists of a dual input operational amplifier 1 having two sets of differential inputs 2 and 3 each of which is selectable by an appropriate voltage applied to a switch control terminal 4. The amplifier is connected to function as an inverting amplifier in one mode of operation, and as a non-inverting amplifier when in the other mode. Thus, input current on common input terminal 5 is applied to the negative input 2.1 of one pair of input terminals, and to the positive input 3.2 of the other pair. The positive input 2.2 of said one pair of input terminals is connected to ground and a feedback resistor R2 is connected between the negative input 2.1 and the output terminal 6 of the amplifier. Selection of input pair 2 by an appropriate voltage on the switch control terminal 4, in this case an up-level TTL signal, puts the amplifier in inverting mode with the gain determined by the value of resistor R2. The negative input 3.1 of said other pair of input terminals is directly connected to the output terminal 6 and the positive input terminal is shunted to ground through resistor R1. It should be noted that the resistor R1 is equivalent to the resistor R10 in the aforementioned IBM-TDB but for the purposes of the present explanation of operation is shown as being part of the amplifier circuit itself. Selection of input pair 3, in this case by a down-level TTL signal, puts the amplifier in non-inverting mode with the gain determined by the value of resistor R1.

When in inverting mode, the voltage on the input 2.1 is at a virtual earth because of the small differential input voltage required to produce an output from the high gain ($10^2 < A < 10^4$) operational amplifier. Therefore the current flowing through resistor R1 tends to zero. Accordingly, since the current flowing into the amplifier also tends to zero, all the input current $I_{in}$ from input terminal 5 flows through R2 generating a negative output voltage, $V_n = -I_{in} \times R2$.

When in non-inverting mode, the amplifier operates in voltage follower mode with the output voltage following the voltages on input 3.2. In this case, the current flowing through resistor R2 tends to zero and, since the current in the amplifier also tends to zero, all the input current $I_{in}$ from input terminal 5 flows through R1 generating a positive output voltage $V_n = I_{in} \times R1$.

The integrated circuit realisation of this circuit is shown in Figure 2 where the same reference numerals as used in Figure 1 are used to identify corresponding items. The operational amplifier input stage consist of transistors T1 and T2 connected in a long-tailed pair configuration as the non-inverting portion, and transistors T3 and T4 similarly connected as the inverting portion.

The differential inputs 2 and 3 of the amplifier are provided by the base connections to the four transistors. Thus, current input signals $I_{in}$ on common input terminal 5 are applied directly to the base of transistor T1 (the positive input 3.2 of the non-inverting portion of the amplifier) and to the base of transistor T4 (the negative input 2.1 of the inverting portion). The base of transistor T2 (the negative input 3.1 of the non-inverting portion) is connected to the amplifier output terminal 6 and the base of transistor T3 (the positive input 2.2 of the inverting portion) is connected to ground. Additionally, the positive input 3.2 to transistor T1 (and the negative input 2.1 to transistor T4) is shunted to ground through resistor R1. Finally, the negative input 2.1 of the transistor T4 (and the positive input 3.2 of transistor T1) is connected to the amplifier output terminal 6 via resistor R2.

The emitters of the transistor T1, T2, T3 T4 combinations are connected to further transistors T5 and T6 respectively. These transistors are themselves connected in a long-tailed pair configuration to a current source provided by transistor T7 and resistor R3. Transistors T5 and T6 are operated as a switch to select one or other of the two portions of the operational amplifier input stages. The current source T7 R3 draws a current, the relative value of which is $2I_1$, so that in the absence of input current to the amplifier, a current $I_1$ flows through each transistor T1 and T2, or T3 and T4 of the selection portion of the amplifier.

Switching of the transistors T5 and T6 controlling the selection of the inverting or non-inverting portions of the amplifier, is by means of a TTL level signal applied to switch control terminal 4. This terminal 4 supplies the base of transistor T8 which has its collector/emitter path connected in series with resistor R4 and current source T9, R5 combination. The current source defines a constant current $I2$, of a similar magnitude to constant current $I1$. A predetermined voltage V at node 7 is connected to the base of switch transistor T5. The magnitude of the voltage V varies in accordance with the magnitude of the signal applied to terminal 4, and is arranged to swing about a reference voltage $V_{ref}$ produced at node 8 and connected to the base of the other switch transistor T6. The reference voltage $V_{ref}$ is defined by an identical constant current $I2$ drawn through transistor T10 connected to function as a diode, and resistors R6, R7 in series with transistors T11 and T12 both of which are also connected to function as diodes. The value of $V_{ref}$ is fixed at twice the Vbe drop of the two diodes T11, T12 below ground potential.

In operation, an up-level polarity select signal on terminal 4 causes the voltage on the base of transistor T5 to rise above $V_{ref}$ switching on transistor T5 and selecting the non-inverting portion of the amplifier. A down-level polarity select signal on terminal 4 causes the voltage V to fall below $V_{ref}$ switching on transistor T6 and selecting the inverting portion of the amplifier. To avoid saturating transistor T5, the voltage swing on its base is limited to one Vbe above ground by transistor T13 connected as a clamping diode between the bases of transistors T5 and T6.

The operation of the amplifier is as described with reference to Figure 1. Thus, in non-inverting mode, with transistors T1 and T2 conducting with the base of transistor T2 tied to the output voltage at terminal 6, the negative feedback of the link between output and base of transistor T2 causes the output voltage to equal that of the base of transistor T1. Accordingly all input current $I_{in}$ flows through resistor R1 giving a positive voltage $I_{in}$ R1 at output terminal 6. No current flows through resistor R2, both ends of which are at the output voltage.

In inverting mode, with transistors T3 and T4 conducting and with the base of transistor T3 tied to ground, the base of transistor T4 is also at ground by virtue of the negative feedback of resistor R2. Accordingly, the input current flows from ground potential through resistor R2 to output terminal 6 giving a negative voltage $-I_{in}$ R2 at output terminal 6. No current flows through resistor R1 which has one end tied to ground and the other end at a virtual ground.

Current through transistors T2 and T4, depending on the selected mode of operation, is applied to a current mirror combination of transistors T14, T15, T16 and T17 and resistor R8 to ground to mirror the current into the emitter/collector path of transistor T15. The arrangement is such that the nominal current $I1$ out of transistor T15 just meets the requirements of its current source provided by transistor T18 resistor R9 combination, defining a constant current of $I1$. Changes in the nominal current value as a result of input current $I_{in}$ through the amplifier forces current into the base of transistor T19 having resistor R10 in its emitter path which provides a corresponding voltage swing at its collector. Since the voltages involved are small, a further transistor T20 connected on a Darlington configuration is coupled to receive and further amplify the signal. The output voltage on the collector of transistor T20 is the output voltage appearing at output terminal 6.

**Claims**

1. A dual polarity switchable operational amplifier circuit, comprising first and second amplifiers each having a pair of differential inputs (3.2, 3.1; 2.2, 2.1) and a pair of differential outputs, switch means operable in response to a polarity select signal for selecting one or other amplifier for operation, and inputer terminal (5) connected to a selected one input (3.2; 2.1) of each pair of inputs to each amplifier and output means for supplying to an output terminal (6) signals derived from a selected one of said differential outputs from each amplifier, the arrangement being such that in response to an input signal applied to said input terminal, a corresponding output voltage is derived at said output terminal, said output voltage being of one polarity when said first amplifier is selected and of the opposite polarity when said second amplifier is selected, characterized in that said output means includes a high gain current-to-voltage converter (T14—T20, R9—R10) interposed between a common node connected to one output selected from each pair of said differential outputs and said output terminal, the other input (3.1) of said first differential amplifier is directly connected to said output terminal and the other input (2.2) of said second differential amplifier is directly connected to a source of reference potential, the input terminal being further connected through a first resistor (R1) to said reference potential and through a second resistor (R2) to said output terminal, whereby in use in response to an input current applied to said input terminal the gain of the operational amplifier circuit is determined by the value of said first resistor when the first amplifier is selected and by the value of said second resistor when the second amplifier is selected.

2. A dual polarity switchable operational amplifier as claimed in claim 1, in which said first amplifier comprises first and second transistors (T1, T2) connected in long-tail pair configuration and said second amplifier comprises third and fourth transistors (T3, T4) connected in long-tail pair configuration, said switch means being connected to the respective tail connections of the first and second amplifiers and being operable in one state to enable only the first and second transistors to conduct and operable in the other state to enable only the third and fourth transistors to conduct, said input terminal being connected to the input electrode (base) of the first transistor of the first amplifier and the input electrode (base) of the second transistor of the second amplifier, and the output electrode (collector of the second transistor of the first amplifier and the output electrode (collector) of the second transistor of the second amplifier being connected to said common node.

3. A dual polarity switchable operational amplifier as claimed in claim 2, in which switch means operates to connect a constant current source $(2I_1)$ into the tail connection of either said first amplifier (T1, T2) or said second amplifier (T3, T4).

4. A circuit as claimed in claim 3, in which said switch means consists of a fifth and sixth transistor (T5, T6) long-tail pair configuration, said fifth transistor (T5) being connected in the tail of said first and second transistor long-tail pair configuration (T1, T2) and said sixth transistor (T6) being connected in the tail of said third and fourth long-tail pair configuration (T3, T4), the alternate states of the switch, wherein one transistor is conducting and the other non-conducting, being determined by the relative levels of voltages applied to the bases of the transistors (T5, T6), and the nominal current through the two transistors (T1, T2 or T3, T4) of the selected long-tail pair configuration of the amplifier being determined by said constant current source (T7, R3) connected as the tail of the long-tail pair configuration (T5, T6) of said switch means.

5. A circuit as claimed in claim 4, in which the base of the sixth transistor (T6) is connected to a predetermined reference voltage $(V_{ref})$ and a switching voltage (V) derived from said polarity select signal, and having a value either above or below said reference voltage $(V_{ref})$, is applied to the base of said fifth transistor (T5).

6. A circuit as claimed in claim 1, in which said current-to-voltage converter comprises a current mirror circuit (T14—T17, R8) operable to mirror emitter/collector current transistors (T2, T4) connected thereto into a constant current source (T18, R9), the current requirements of which correspond to the nominal emitter/collector current of said transistors when conducting, a voltage being derived therefrom proportional to variations in nominal emitter/collector current (I1) caused by an input current $(I_{in})$ at said input (5) and said voltage being amplified and supplied at said output voltage (Vo) to said circuit output (6).

7. A circuit as claimed in any one of the preceding claims in which the first and second resistors (R1, R2) are of identical value.

**Patentansprüche**

1. Schaltbare Zweipolaritäts-Operationsverstärkerschaltung mit einem ersten und zweiten Verstärker, von denen jeder ein Paar von Differenzeingängen (3.2, 3.1; 2.2, 2.1) und ein Paar von Differenzausgängen aufweist, ansprechend auf ein Polaritätsauswahlsignal arbeitenden Schaltmitteln zur Auswahl des einen oder anderen Verstärkers für den Betrieb, einem Eingangsanschluß (5), welcher mit einem ausgewählten Eingang (3.2; 2.1) eines jeden Paares von Eingängen eines jeden Verstärkers verbunden ist, und Ausgangsmitteln zur Lieferung von von einem ausgewählten der Differenzausgänge eines jeden Verstärkers abgeleiteten Signalen auf einen Ausgangsanschluß (6), wobei die Anordnung so ist, daß ansprechend auf ein auf den Eingangsanschluß gegebenes Eingangssignal eine entsprechende Ausgangsspannung am Ausgangsanschluß abgeleitet wird, wobei die Ausgangsspannung die eine Polarität hat, wenn der erste Verstärker ausgewählt wird, und die entgegengesetzte Polarität, wenn der zweite Verstärker ausgewählt wird, dadurch gekennzeichnet, daß die Ausgangsmittel einen Strom-Spannungsumsetzer (T14—T20, R9—R10) aufweisen, welcher zwischen einem gemeinsamen Knoten, welcher mit einem der Ausgänge eines jeden Paares der Differenzausgänges verbunden ist, und dem Ausgangsanschluß liegt, daß der andere Eingang (3.1) des ersten Differenzverstärkers direkt mit dem Ausgangsanschluß und der andere Eingang (2.2) des zweiten Differenzverstärkers direkt mit einer Quelle für ein Referenzpotential verbunden ist, wobei der Eingangsanschluß ferner über einen ersten Widerstand (R1) mit dem Referenzpotential und über einen zweiten Widerstand (R2) mit dem Ausgangsanschluß verbunden ist, wobei im Gebrauch ansprechend auf einen auf den Eingangsanschluß gegebenen Eingangsstrom die Verstärkung der Operationsverstärkerschaltung durch den Wert des ersten Widerstands, wenn der erste Verstärker ausgewählt ist, und durch den Wert des zweiten Widerstands, wenn der zweite Verstärker ausgewählt ist, bestimmt wird.

2. Schaltbarer Zweipolaritäts-Operationsverstärker nach Anspruch 1, bei welchem der erste Verstärker einen ersten und zweiten Transistor (T1, T2), die in Differenz-(long-tail pair)Konfiguration verbunden sind, und der zweite Verstärker einen dritten und vierten Transistor (T3, T4), die in Differenz-(long-tail pair)Konfiguration verbunden sind, umfaßt, wobei die Schaltmittel mit den betreffenden Differenz-(tail)Verbindungen des ersten und zweiten Verstärkers verbunden sind und in einem Zustand so arbeiten, daß nur der erste und zweite Transistor leiten kann, und im anderen Zustand so arbeiten, daß nur der dritte und vierte Transistor leiten kann, wobei der Eingangsanschluß mit der Eingangselektrode (Basis) des ersten Transistors des ersten Verstärkers und der Eingangselektrode (Basis) des zweiten Transistors des zweiten Verstärkers verbunden ist, und die Ausgangselektrode (Kollektor) des zweiten Transistors des ersten Verstärkers und die Ausgangselektrode (Kollektor) des zweiten Transistors des zweiten Verstärkers mit dem gemeinsamen Knoten verbunden sind.

3. Schaltbarer Zweipolaritäts-Operationsverstärker nach Anspruch 2, bei welchem die Schaltmittel eine Konstantstromquelle (2I₁) in die Differenz-(tail)Verbindung entweder des ersten Verstärkers (T1, T2) oder des zweiten Verstärkers (T3, T4) schaltend arbeiten.

4. Schaltung nach Anspruch 3, bei welcher die Schaltmittel aus einer Differenz-(long-tail pair)-Konfiguration eines fünften und sechsten Transistors (T5, T6) bestehen, wobei der fünfte Transistor (T5) ins Ende (tail) der aus dem ersten und zweiten Transistor aufgebauten Differenz-(long-tail pair)Konfiguration (T1, T2) geschaltet ist und der sechste Transistor (T6) ins Ende (tail) der aus dem dritten und vierten Transistor aufgebauten Differenz-(long-tail pair)Konfiguration (T3, T4) geschaltet ist, wobei die wechselnden Zustände des Schalters, in welchen ein Transistor leitet und der andere nichtleitend ist, durch die relativen Pegel von auf die Basen der Transistoren (T5, T6) gegebenen Spannungen bestimmt wird und der Nennstrom durch die beiden Transistoren (T1, T2 oder T3, T4) der ausgewählten Differenz-(long-tail pair)Konfiguration des Verstärkers durch die Konstantstromquelle (T7, R3), die als Ende (tail) der Differenz-(long-tail pair)Konfiguration (T5, T6) der Schaltmittel verschaltet ist, bestimmt wird.

5. Schaltung nach Anspruch 4, bei welcher die Basis des sechsten Transistors (T6) an eine bestimmte Referenzspannung (V$_{ref}$) angeschlossen ist und eine Schaltspannung (V), welche von dem Polaritäts-Auswahlsignal abgeleitet ist und eine entweder oberhalb oder unterhalb der Referenzspannung (V$_{ref}$) liegenden Wert hat, auf die Basis des fünften Transistors (T5) gegeben wird.

6. Schaltung nach Anspruch 1, bei welcher der Strom-Spannungsumsetzer eine Stromspiegelschaltung (T14—T17, R8) umfaßt, die so betreibbar ist, daß damit verbundene Emitter/Kollektorstromtransistoren (T2, T4) in eine Konstantstromquelle (T18, R9) gespiegelt werden, deren Stromerfordernisse dem nominalen Emitter/Kollektorstrom der Transistoren, wenn diese leitend sind, entsprechen, wobei von dort eine Spannung abgeleitet wird, die Schwankungen des nominalen Emitter/Kollektorstromes (I1) proportional sind, die durch einen Eingangsstrom (I$_{in}$) am Eingang (5) verursacht sind, und die Spannung verstärkt und auf der Ausgangsspannung (Vo) dem Schaltungsausgang (6) zugeführt wird.

7. Schaltung nach irgendeinem der vorstehenden Ansprüche, bei welcher der erste und zweite Widerstand (R1, R2), identischen Wert haben.

**Revendications**

1. Un circuit d'amplificateur opérationnel commutable à double polarité, comprenant un premier et un second amplificateurs ayant chacun une paire d'entrées différentielles (3.2, 3.1; 2.2, 2.1) et une paire de sorties différentielles, des moyens de commutation pouvant fonctionner en réponse à un signal de sélection de polarité permettant de sélectionner le fonctionnement de l'un ou l'autre amplificateur, une borne d'entrée (5) reliée à chaque amplificateur par l'une des entrées sélectionnées (3.2; 2.1) de chaque paire d'entrées, et des moyens de sortie pour appliquer à une borne de sortie (6) des signaux provenant de l'une des sorties différentielles sélectionnées de chaque amplificateur, l'ensemble étant constitué de telle sorte que, en réponse à un signal d'entrée appliqué à la borne d'entrée, on obtienne une tension de sortie correspondante à la borne de sortie, la tension de sortie étant de l'une des polarités lorsque le premier amplificateur est sélectionné et de la polarité opposée lorsque le second amplificateur est sélectionné, caractérisé en ce que les moyens de sortie comprennent un convertisseur courant-tension (T14—T20, R9—R10) intercalé entre un noeud commun relié à l'une des entrées choisies de chaque paire de sorties différentielles et la borne d'entrée, l'autre entrée (3.1) du premier amplificateur différentiel étant directement reliée à la borne de sortie et l'autre entrée (2.2) du second amplificateur différentiel étant directement reliée à une source de potentiel de référence, la borne d'entrée étant en outre reliée par une première résistance (R1) à ce potentiel de référence et par une seconde résistance (R2) à la borne de sortie, de sorte que, en cours d'utilisation, en réponse à un courant d'entrée appliqué à la borne d'entrée le gain du circuit amplificateur opérationnel soit déterminée par la valeur de la première résistance lorsque l'on sélectionne le premier amplificateur, et par la valeur de la seconde résistance lorsque l'on sélectionne le second amplificateur.

2. L'amplificateur opérationnel commutable à double polarité de la revendication 1, dans lequel le premier amplificateur comprend un premier et un second transistors (T1, T2) montés en paire à longue queue, et dans lequel le second amplificateur comprend un troisième et un quatrième transistors (T3, T4) montés en paire à longue queue, lesdits moyens de commutation étant reliés aux liaisons de queue respectives du premier et du second amplificateurs et pouvant fonctionner dans l'un des états pour permettre seulement au premier et au second transistors d'être conducteurs et pouvant fonctionner dans l'autre état pour permettre seulement au troisième et au quatrième transistors d'être conducteurs, la borne d'entrée étant reliée à l'électrode d'entrée (base) du premier transistor du premier amplificateur et l'électrode d'entrée (base) du second transistor du second amplificateur, et l'électrode de sortie (collecteur) du second transistor du premier amplificateur et l'électrode de sortie (collecteur) du second transistor du second amplificateur étant reliées audit noeud commun.

3. L'amplificateur opérationnel commutable à double polarité de la revendication 2, dans lequel lesdits moyens de commutation fonctionnent de manière à connecter une source de courant constant (2.1I) dans la liaison de queue soit du premier amplificateur (T1, T2), soit du second amplificateur (T3, T4).

4. Le circuit de la revendication 3, dans lequel lesdits moyens de commutation consistent en un cinquième et un sixième transistors (T5, T6) montés en paire à longue queue, le cinquième transistor (T5) étant relié à la queue du montage en paire à longue queue du premier et du second transistors (T1, T2), et le sixième transistor étant relié à la queue du montage en paire à longue queue du troisième et du quatrième transistors (T3, T4), et les état alternés du commutateur, pour lesquels l'un des transistors est conducteur et l'autre ne l'est pas, étant déterminés par les niveaux relatifs des tensions appliquées aux bases des transistors (T5, T6), et le courant nominal traversant les deux transistors (T1, T2 ou T3, T4) du montage en paire à longue queue choisi de l'amplificateur étant déterminé par ladite source de courant constant (T7, R3) reliée à la queue du montage en paire à longue queue (T5, T6) desdits moyens de commutation.

5. Le circuit de la revendication 4, dans lequel la base du sixième transistor (T6) est reliée à une tension de référence prédéterminée ($V_{ref}$), et dans lequel on applique à la base du cinquième transistor (T5) une tension de commutation (V) obtenue à partir du signal de sélection de polarité, et ayant une valeur située soit au dessus soit au dessous de la tension de référence ($V_{ref}$).

6. Le circuit de la revendication 1, dans lequel le convertisseur courant/tension comprend un circuit à courant miroir (T14—T17, R8) fonctionnant de manière à produire un courant miroir du courant émetteur/collecteur des transistors (T2, T4) qui y sont reliés vers une source de courant constant (T18, R9), dont les besoins en courant correspondent au courant nominal émetteur/collecteur de ces transistors lorsqu'ils sont conducteurs, une tension en étant dérivée qui est proportionnelle aux variations du courant nominal émetteur/collecteur (I1) produites par un courant d'entrée ($I_{in}$) sur ladite entrée (5), cette tension étant amplifiée et appliquée comme tension de sortie ($V_0$) à la sortie (6) du circuit.

7. Le circuit de l'une quelconques des revendications précédentes, dans lequel la première et la seconde résistances (R1, R2) ont des valeurs identiques.

0 090 104

F I G. I

FIG. 2